**Europäisches Patentamt**

**European Patent Office**

**Office européen des brevets**

(19)

(11) Veröffentlichungsnummer : **0 084 126
B1**

(12) **EUROPÄISCHE PATENTSCHRIFT**

(45) Veröffentlichungstag der Patentschrift :
28.08.85

(51) Int. Cl.⁴ : **C 23 C 14/24, C 23 C 14/50**

(21) Anmeldenummer : **82111605.0**

(22) Anmeldetag : **14.12.82**

(54) **Vorrichtung zum Beschicken von Verdampfern in Aufdampfanlagen.**

(30) Priorität : **14.01.82 DE 3200848**

(43) Veröffentlichungstag der Anmeldung :
**27.07.83 Patentblatt 83/30**

(45) Bekanntmachung des Hinweises auf die Patenterteilung : **28.08.85 Patentblatt 85/35**

(84) Benannte Vertragsstaaten :
**AT BE CH DE FR GB IT LI LU NL SE**

(56) Entgegenhaltungen :
**DE-B- 1 032 998
PATENT ABSTRACTS OF JAPAN, unexamined applications, C Field, Vol. 5, No. 67, 7. Mai 1981 THE PATENT OFFICE JAPANESE GEVERNMENT Seite 72 C 53
SOVIET INVENTIONS ILLUSTRATED, Sektion Ch, Woche D 17, 3. Juni 1981 DERWENT PUBLICATIONS LTD., London, J 04**

(73) Patentinhaber : **GfO Gesellschaft für Oberflächentechnik m.b.H.
Klarenbergstrasse 79 Postfach 12 40
D-7070 Schwäbisch Gmünd (DE)**

(72) Erfinder : **Rachor, Lothar
Seligenstädterstrasse 79
D-6450 Hanau 8 (DE)**
Erfinder : **Eichinger, Erwin, Dipl.-Ing.
Am hohen Berg
D-7071 Leinzell (DE)**
Erfinder : **Scheyrer, Peter, Dipl.-Ing.
Kaffeebergweg 16
D-7070 Schwäbisch Gmünd (DE)**
Erfinder : **Seif, Rudolf, Dr. Dr. Ing.
Im Rosenring 33
D-6454 Bruchköbel (DE)**

(74) Vertreter : **Nowak, Gerhard
DEGUSSA AG Fachbereich Patente Postfach 1345
D-6450 Hanau 1 (DE)**

**Beschreibung**

Die Erfindung betrifft eine Vorrichtung zum Beschicken von Verdampfern in Aufdampfanlagen mit Formstücken aus Aufdampfmaterialien.

Dünne Schichten von Stoffen, insbesondere von Metallen, können auf verhältnismäßig einfache Weise dadurch erhalten werden, daß man die entsprechenden Substanzen im Vakuum verdampft und die entstehenden Dämpfe auf den entsprechenden Substraten niederschlägt. Die Verdampfung der aufzubringenden Substanzen erfolgt dabei in sogenannten Verdampfern durch Aufheizung oder auch mittels Elektronenstrahlen.

Das Aufdampfen dünner Schichten auf begrenzten Flächen mit einem einheitlichen Aufdampfmaterial ist verhältnismäßig einfach. Kompliziertere Vorrichtungen sind notwendig bei der Bedampfung endloser Bänder, bei der Aufdampfung von Legierungsschichten oder mehrerer Schichten aus verschiedenen Substanzen, vor allem wegen der fortlaufenden Beschickung der Verdampfer mit den Aufdampfmaterialien ohne Unterbrechung des Vakuums, was zu Verschlechterungen in der Schichtqualität führen würde. Bei der Unterbrechung des Vakuums zwecks Neubeschickung der Verdampfer kommt erschwerend hinzu, daß ein mehrfaches Auspumpen der Aufdampfanlage unwirtschaftlich ist.

Es ist bekannt, Schichten aus mehreren Komponenten auf Substraten durch Aufdampfen im Vakuum aufzubringen, indem man die Substrate nacheinander über Verdampfer mit den entsprechenden Substanzen bringt (DE-OS 19 10 332). Diese Verfahren und Vorrichtungen können jedoch nur mit einer begrenzten Menge von Aufdampfmaterialien in der Anlage arbeiten. Die gleichen Nachteile treten auf, wenn man Verdampfer mit verschiedenen Aufdampfmaterialien auf einem Drehteller angeordnet und nacheinander beheizt (DE-AS 12 98 833).

Es sind weiterhin Vorrichtungen bekannt, mit denen die Aufdampfmaterialien während des Aufdampfprozesses bzw. unter Aufrechterhaltung des Vakuums kontinuierlich den Verdampfern zugeführt werden können. So wird beispielsweise in der DE-PS 75 2 141 das Aufdampfmaterial in Drahtform von einer Vorratsrolle abgezogen und direkt dem erhitzten Verdampfertiegel zugeführt, wo es verdampft und auf dem Substrat niedergeschlagen wird. Außerdem ist es aus der DE-AS 10 32 998 bekannt, die zu verdampfenden substanzen in Form von kleinen Körnchen durch eine geeignete Vorrichtung auf den hocherhitzten Verdampfer fallen zu lassen. Diese Beschickungsvorrichtungen haben jedoch den Nachteil, daß sie gesondert gekühlt werden müssen wegen der hohen Wärmebelastung in der Anlage und bei der Aufdampfung störende « Schatten » werfen können.

Es war daher Aufgabe der vorliegenden Erfindung, eine Vorrichtung zum Beschicken von Verdampfern in Aufdampfanlagen mit Formstücken aus Aufdampfmaterialien zu schaffen, mit der ohne Unterbrechung des Vakuums die Verdampfer mehrmals nachbeschickt werden können, ohne daß eine besondere Kühlung notwendig wäre und ein « Schattenwurf » auftritt.

Diese Aufgabe wurde erfindungsgemäß gelöst durch eine zur Aufnahme der Formstücke mit Einkerbungen versehene, auf einer drehbaren Achse zentrierten und von einem einganliegenden Gehäuse umgebenen Rolle, ein and er Achse befestigtes Bewegungselement mit schrittweisen Vorschub und eine in eine Ruhe- und eine Beschickungsstellung bringbare Schwenkachse, an der über Befestigungselemente die Achse mit der Rolle angebracht ist, wobei das Gehäuse der Rolle mit einer den Formstücken entsprechenden Ausnehmung versehen ist, die sich in der Beschickungsstellung der Schwenkachse unmittelbar oberhalb des Verdampfers befindet.

Als Formkörper können beispielsweise Plättchen, Kugeln oder vorzugsweise Drahtabschnitte verwendet werden, wobei diese jeweils aus dem gleichen Material oder bei der Herstellung von verschiedenen Schichten aus verschiedenen Aufdampfmaterialien bestehen können.

Falls die Aufdampfanlage mehrere Verdampfer besitzt, ist es von Vorteil, jedem Verdampfer eine eigene Beschickungsrolle zuzuordnen, die entweder auf der gleichen oder auf verschiedenen Achsen sitzen. Das Bewegungselement ist vorzugsweise als Sperrad ausgebildet, das beim Schwenken der Schwenkachse in die Beschickungsstellung in eine ortsfeste Sperrklinke einrastet und die Achse mit der Beschickungsrolle jeweils um eine Position weiterbewegt. Außerdem ist es vorteilhaft, die Schwenkachse vakuumdicht aus der Aufdampfanlage herauszuführen und mit einem mechanischen Antrieb außerhalb der Anlage zu versehen.

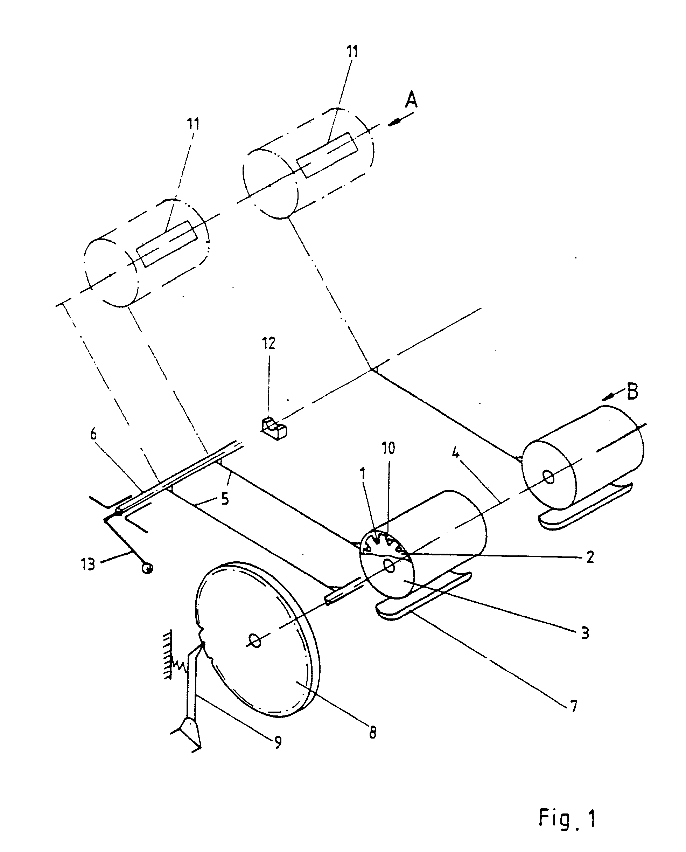

In der Abbildung wird schematisch eine beispielhafte Ausführungsform der erfindungsgemäßen Vorrichtung beschrieben.

Auf einer drehbaren Achse (4) sitzen Rollen (2), die auf ihrem Umfang mit Einkerbungen (10) zur Aufnahme der Formstücke (1) aus den entsprechenden Aufdampfmaterialien versehen und von einem Gehäuse (3) umgeben sind. Die drehbare Achse (4) und gegebenenfalls auch die Gehäuse (3) sind über Befestigungselemente (5) mit einer Schwenkachse (6) verbunden, die in Lagern (12) geführt wird und mittels eines mechanischen Antriebs (13), beispielsweise eines hebels, außerhalb der Anlage in eine Ruhestellung (A) und in eine Beschickungsstellung (B) geschwenkt werden kann. An der drehbaren Achse (4) ist ein Bewegungselement (8) mit schrittweisen Vorschub angebracht, im vorliegenden Fall ein Sperrad, das beim Schwenken der Schwenkachse (6) in die Beschickungsstellung (B) in eine ortsfeste Sperrklinke (9) einrastet und die drehbare Achse (4) entsprechend dem Zahnabstand des Sperrades (8) um eine Position weiterdreht. Durch die Ausnehmung (11) im Gehäuse (3) der Rolle (2) fällt dann ein Formkörper (1) aus der Einkerbung (10) der Rolle (2) in den Verdampfer (7). Anschließend wird die Schwenkachse (6) wieder in die Ruhestellung (A) gebracht, wo sie die Aufdampfung nicht durch Schattenwirkung beeinträchtigt und auch keiner extremen Hitzeeinwirkung ausgesetzt ist, die eine Kühlung erforderlich machen würde. Durch den nur kurzzeitigen Aufenthalt der Rollen (2) an den Verdampfern (7) kann die Beschickung bei aufgeheizten Verdampfern (7) erfolgen.

**Patentansprüche**

1. Vorrichtung zum Beschicken von Verdampfern in Aufdampfanlagen mit Formstücken aus Aufdampfmaterialien, gekennzeichnet durch eine zur Aufnahme der Formstücke (1) mit Einkerbungen (10) versehene, auf einer drehbaren Achse (4) zentrierten und von einem enganliegenden Gehäuse (3) umgebenen Rolle (2), ein an der Achse (4) befestigtes Bewegungselement (8) mit schrittweisen Vorschub und eine in eine Ruhe- und eine Beschickungsstellung bringbare Schwenkachse (6), an der über Befestigungselemente (5) die Achse (4) mit Rolle (2) angebracht ist, wobei das Gehäuse (3) der Rolle (2) mit einer den Formstücken (1) entsprechenden Ausnehmung (11) versehen ist, die sich in der Beschickungsstellung der Schwenkachse (6) unmittelbar oberhalb des Verdampfers (7) befindet.

2. Vorrichtung zum Beschicken von Verdampfern nach Anspruch 1, dadurch gekennzeichnet, daß das Bewegungselement (8) als Sperrrad ausgebildet ist, das beim Schwenken der Schwenkachse (6) in die Beschickungsstellung in eine ortsfeste Sperrklinke (9) einrastet.

3. Vorrichtung zum Beschicken von Verdampfern nach Anspruch 1 und 2, dadurch gekennzeichnet, daß auf der Achse (4) entsprechend der Zahl der Verdampfer (7) mehrere Rollen (2) sitzen.

4. Vorrichtung zum Beschicken von Verdampfern nach Anspruch 1 bis 3, dadurch gekennzeichnet, daß die Schwenkachse (6) aus der Aufdampfanlage herausgeführt und mit einem mechanischen Antrieb (13) außerhalb der Anlage versehen ist.

**Claims**

1. An apparatus for charging vaporizers in vaporization systems with mouldings of vaporizable materials, characterised by a cylinder (2) for accommodating the mouldings (1), which is provided with notches (10), centred on a rotatable axis (4) and surrounded by a tight housing (3), a moving element (8) fixed to the shaft (4) with stepwise advance and a swivelling shaft (6) which can be brought into a stationary position and a charging position, to which shaft (6) the shaft (4) with the cylinder (2) is attached via fixing elements (5), the housing (3) of the cylinder (2) being provided with a recess (11) corresponding to the mouldings (1), which recess (11), with the swivelling shaft in the charging position, is directly above the vaporizer (7).

2. An apparatus for charging vaporizers according to claim 1, characterised in that the moving element (8) is in the form of a locking wheel, which locks into a fixed catch (9) when the swivelling shaft (6) swivels into the charging position.

3. An apparatus for charging vaporizers according to claims 1 and 2, characterised in that several cylinders (2), corresponding to the number of vaporizers (7), are located on the shaft (4).

4. An apparatus for charging vaporizers according to claims 1 to 3, characterised in that the swivelling shaft (6) is led out of the vaporization system and is provided with a mechanical drive mechanism (13) outside the system.

**Revendications**

1. Dispositif pour alimenter des évaporateurs des installations de vaporisation, avec des pièces moulées en matières à vaporiser, dispositif caractérisé par un cylindre (2) muni d'entailles (10) pour la réception de pièces moulées (1), centré sur un axe rotatif (4) et étroitement entouré par une enveloppe (3), un élément moteur (8) monté sur l'axe (4) avec un avancement pas à pas, et un axe de rotation (6) qui peut être amené dans une position de repos et dans une position d'alimentation, sur lequel l'axe (4) est monté avec le cylindre (2) au moyen d'éléments de fixation (5), l'enveloppe (3) du cylindre (2) étant munie d'un orifice (11) correspondant aux pièces formées (1), cet orifice se trouvant directement au-dessus de l'évaporateur (7) lorsque l'axe de rotation (6) occupe sa position d'alimentation.

2. Dispositif selon la revendication 1, caractérisé en ce que l'élément moteur (8) est une roue dentée qui s'engrène sur un cliquet (9) fixe au cours de la rotation de l'axe (6) dans la position d'alimentation.

3. Dispositif selon les revendications 1 et 2, caractérisé en ce que l'axe (4) porte plusieurs cylindres (2), suivant le nombre des vaporiseurs.

4. Dispositif selon les revendications 1 à 4, caractérisé en ce que l'axe de rotation (6) sort de l'installation de vaporisation et qu'il est muni d'un entraînement mécanique (13) à l'extérieur de l'installation.

Fig. 1